# FASCICULE DE BREVET EUROPEEN

(11) **EP 0 599 745 B1**
(45) Date de publication et mention de la délivrance du brevet: **18.07.2001**
(21) Numéro de dépôt: 93420458.7
(22) Date de dépôt: 19.11.1993
(51) Int. Cl.: H01L 27/02, H01L 29/10

(54) **Structure de protection contre les surtensions directes pour composant semiconducteur vertical**
Überspannungsschutzstruktur für vertikale Halbleiterkomponenten
Protection structure against overvoltages for a vertical semiconductor device

(30) Priorité: 24.11.1992 FR 9214478
(43) Date de publication de la demande: 01.06.1994
(73) Titulaire: STMicroelectronics S.A., 94250 Gentilly (FR)
(72) Inventeur: Barret, Jean, F-13510 Eguilles (FR); Quessada, Daniel, F-83910 Pourrieres (FR)
(74) Mandataire: de Beaumont, Michel

(56) Documents cités:
- EP-A- 0 409 746
- EP-A- 0 416 805
- EP-A- 0 437 939
- EP-A- 0 565 179
- DE-A- 3 540 433
- PATENT ABSTRACTS OF JAPAN vol. 14, no. 362 (E-960) 06 Août 1990 & JP-A-02 128 474 (NEC) 16 Mai 1990

## Description

La présente invention concerne les transistors de puissance verticaux haute tension qui sont des dispositifs réalisés verticalement dans une tranche de silicium dont la face arrière est connectée à une haute tension. L'invention s'applique à des transistors de puissance verticaux de type MOS ou bipolaire à grille isolée. Elle s'applique notamment à des commutateurs de puissance "intelligents" (Smart Power Switch) qui sont des circuits comprenant sur une même puce de silicium des composants de puissance verticaux et des circuits logiques de commande de ces composants.

Les transistors de puissance sont conçus pour supporter une tension directe définie (par exemple 400 volts). Si le circuit externe applique une tension plus importante au dispositif, celui-ci entre dans un mode de claquage susceptible de l'endommager. Par exemple, la commutation d'une charge inductive produit une surtension avec une certaine quantité d'énergie à dissiper. Cette surtension est appliquée sur le commutateur de puissance qui est à l'état bloqué ou dans une phase transitoire de passage à l'état bloqué. L'une des solutions pour protéger le transistor consiste à envoyer un signal sur son électrode de commande pour l'amener brièvement dans un état conducteur pendant la durée nécessaire pour écouler l'énergie excessive.

On cherche donc à prévoir un dispositif qui entre en conduction pour une valeur un peu inférieure à la tension de claquage du ou des transistors de puissance pour, par exemple, déclencher la mise en conduction de ces transistors avant leur seuil de claquage et éviter ainsi tout endommagement.

Dans ce qui suit, on se référera toujours à des transistors de puissance de type MOS. Toutefois, il sera clair que tout ce qui est énoncé à propos de ces transistors s'applique également à des transistors bipolaires à grille isolée (IGBT) qui sont structurellement sensiblement identiques à l'exception du fait qu'ils comprennent du côté de leur face arrière une couche de type de conductivité opposé à celui de la couche constituant la face arrière d'un transistor MOS de puissance.

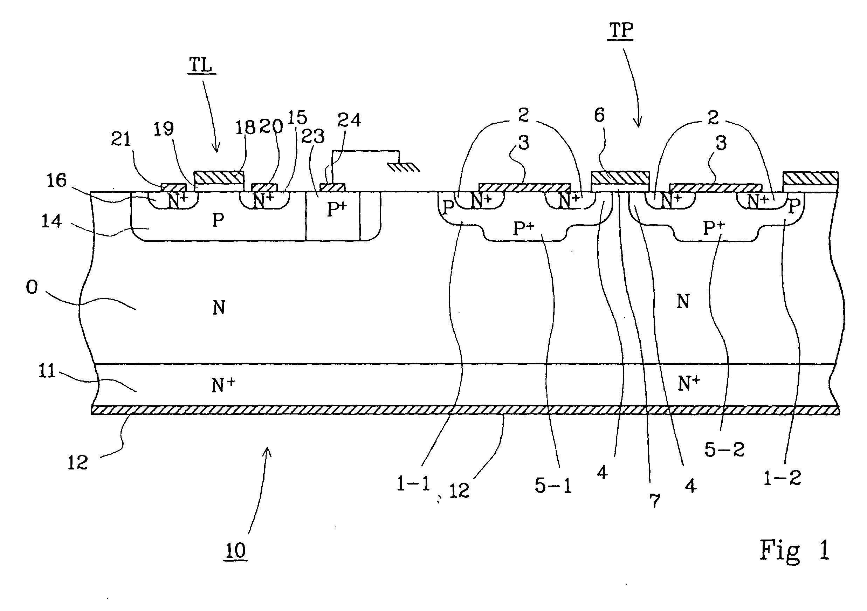

Pour mieux faire comprendre le problème que vise à résoudre la présente invention, la figure 1 représente en coupe un exemple de structure mixte classique comprenant un transistor MOS de puissance vertical TP de type diffusé (VDMOS), dont deux cellules sont représentées, ce transistor étant associé à des circuits logiques dont un transistor MOS à canal N TL est illustré. Le transistor MOS vertical est constitué d'un grand nombre de cellules identiques en parallèle, par exemple 10 000.

La structure est réalisée dans un substrat 0 d'un premier type de conductivité, par exemple de type N. Une cellule du transistor MOS de puissance TP comprend un caisson 1 (1-1, 1-2) constitué d'une diffusion de type P. Dans chaque caisson 1-1, 1-2 est réalisée une diffusion annulaire 2 de type N⁺ qui constitue un élément de la source du transistor de puissance. Les diffusions 2 sont connectées entre elles par une couche conductrice 3 qui est par exemple réalisée en aluminium. Les zones périphériques superficielles des régions 1 constituent une région de canal 4 du transistor de puissance. De plus, chaque caisson 1 comprend généralement une partie centrale plus profonde et plus dopée 5 (5-1, 5-2).

Chaque cellule du transistor MOS de puissance TP comprend une grille 6 formée par une couche de silicium polycristallin. Cette grille 6 est séparée du substrat 1 par une couche d'oxyde 7. Toutes les grilles 6 sont interconnectées.

La face arrière 10 du substrat 1 comprend une couche surdopée 11 revêtue d'une métallisation de drain 12.

Le transistor MOS TL de la partie logique est formé dans un caisson 14 de type P. Ce caisson 14 comporte deux zones diffusées de type N⁺, la première constituant la source 15 et la seconde constituant le drain 16 du transistor TL. Ce transistor comprend une grille 18 constituée par une couche de silicium polycristallin. La grille 18 est séparée du caisson 14 par une couche d'oxyde 19. Les zones diffusées constituant la source 15 et le drain 16 sont chacune connectée à une ligne conductrice désignée par 20, 21, respectivement. Les lignes conductrices 20, 21 sont par exemple en aluminium.

De façon classique, on prévoit dans le caisson 14 une zone 23 de type P⁺ connectée à une couche conductrice 24. La zone 23 et la couche conductrice 24 permettent la mise à la masse du caisson 14.

En fonctionnement normal, la métallisation de face arrière 12 est connectée à un potentiel positif et les métallisations de face avant 3 du transistor de puissance sont connectées à un potentiel négatif par rapport à ce potentiel positif, par exemple un potentiel voisin du potentiel de la masse.

Le problème que l'on veut résoudre est d'éviter la mise en conduction par claquage du transistor de puissance, c'est-à-dire de la jonction entre le substrat 0 et les caissons P (1-1, 5-1 ; 1-2, 5-2) quand la tension de drain croit alors que le transistor est à l'état bloqué. Cette mise en conduction est indésirable car elle peut provoquer un échauffement de la zone où se crée l'avalanche en raison d'une circulation de courant excessive et cet échauffement peut être destructif. On notera qu'il y a aussi, dans le cas représenté d'un circuit intégré comprenant une partie logique, un risque de claquage de la jonction entre le substrat et les caissons dans lesquels sont disposés les composants logiques. Classiquement, la structure est conçue pour que cette dernière jonction claque après celle des cellules des transistors de puissance.

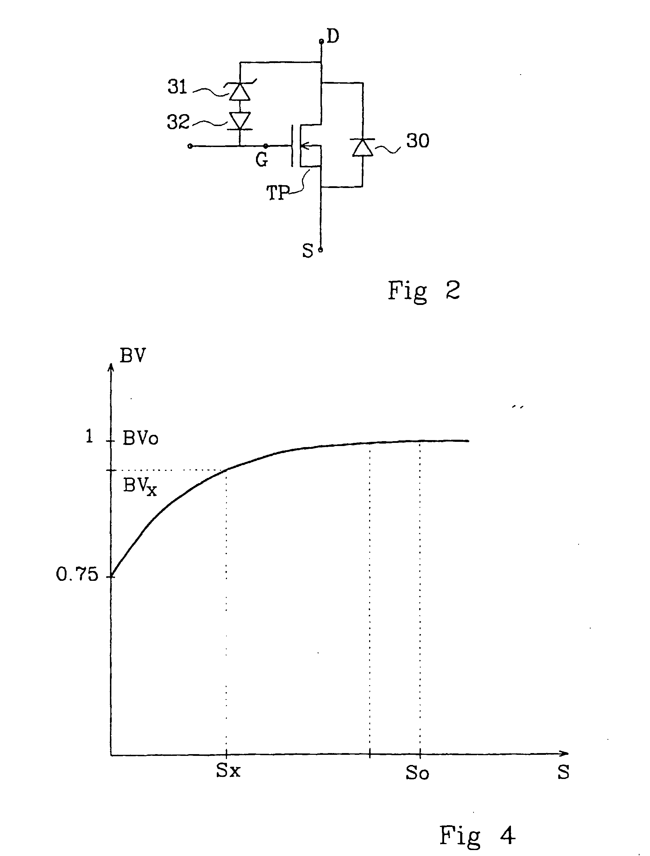

Une diode à avalanche ayant un seuil de déclenchement inférieur à celui des cellules du transistor MOS de puissance peut être utilisée de façon classique, par exemple comme cela est illustré en figure 2 où est représenté le transistor de puissance TP avec ses bornes de drain D, de source S et de grille G. Ce transistor comprend une diode de conduction inverse 30. Une diode à avalanche 31 peut être connectée entre le drain et la grille avec de préférence interposition d'une diode directe série 32 pour éviter toute dérivation des signaux normaux de commande de grille. Le circuit de la figure 2 n'est représenté qu'à titre d'exemple car de nombreux autres montages de déclenchement d'un transistor principal après déclenchement d'une diode à avalanche de détection sont connus. On notera que, dans la plupart de ces montages, comme cela est illustré en figure 2, la cathode de la diode à avalanche est connectée au drain du transistor de puissance. Cette cathode ou ce drain correspond à la borne commune 12 de la figure 1.

Une approche différente est décrite dans la demande de brevet européen 0 416 805 dans laquelle chaque cellule d'un transistor MOS de puissance est dessinée de façon spécifique avec une diode à avalanche centrale qui entre dans le mode d'avalanche un peu avant les cellules du transistor de puissance. Cette structure présente deux inconvénients. Le premier est qu'elle nécessite une reconception, un redessin, de toutes les cellules d'un transistor MOS de puissance alors que, normalement, les fabricants de transistors MOS de puissance ont déjà réalisé pour des produits antérieurs des cellules optimisées. Cette reconception nécessite un important travail de redessin sans bénéficier des travaux antérieurs déjà réalisés par le fabricant. Le deuxième inconvénient est que des travaux d'ajustement importants sont nécessaires pour concevoir la forme de la diode à avalanche pour que son seuil de déclenchement soit bien déterminé par rapport au seuil de déclenchement en avalanche des cellules du transistor de puissance.

Ainsi, un objet de la présente invention est de prévoir dans un transistor de puissance de type vertical, une structure de protection contre les surtensions directes qui puisse être réalisée dans une plaquette semiconductrice contenant un composant semiconducteur de puissance sans nécessiter une modification de la structure (du dessin) des cellules du transistor de puissance.

Un autre objet de la présente invention est de prévoir une telle structure de protection dont le seuil de déclenchement soit déterminé avec précision par rapport au seuil de déclenchement en avalanche des cellules du transistor de puissance.

Un autre objet de la présente invention est de prévoir une telle structure de protection qui puisse être réalisée sans modifier le procédé de fabrication du composant comprenant un ou plusieurs transistors de puissance et éventuellement un circuit logique de commande.

Pour atteindre ces objets, la présente invention prévoit un transistor de puissance vertical de type MOS ou IGBT tel que revendiqué dans les revendications 1 à 3.

Du fait que la structure de protection selon la présente invention utilise comme élément détecteur une cellule identique à celles du transistor de puissance, mais seulement de plus petite dimension, le seuil de déclenchement de cette cellule est déterminé de façon fiable et reproductible par rapport au seuil de déclenchement en avalanche directe des cellules du transistor de puissance. Notamment, si l'un quelconque des paramètres de fabrication dérive, la dérive sera identique pour les cellules de détection et pour les cellules du transistor de puissance et la différence de seuil de déclenchement restera sensiblement la même.

Ces objets, caractéristiques et avantages ainsi que d'autres de la présente invention seront exposés en détail dans la description suivante d'un mode de réalisation particulier faite en relation avec les figures jointes parmi lesquelles :
la figure 1 représente une vue en coupe partielle d'un composant incluant un transistor VDMOS et des composants logiques ;
la figure 2 représente un circuit de protection contre des surtensions directes d'un transistor MOS de puissance;
la figure 3 représente une vue en coupe partielle d'un transistor VDMOS muni d'un élément détecteur de surtension selon la présente invention ;
la figure 4 est un graphique illustrant la tension de claquage d'une cellule en fonction de sa dimension ; et
la figure 5 représente une vue en coupe partielle d'un transistor VDMOS.

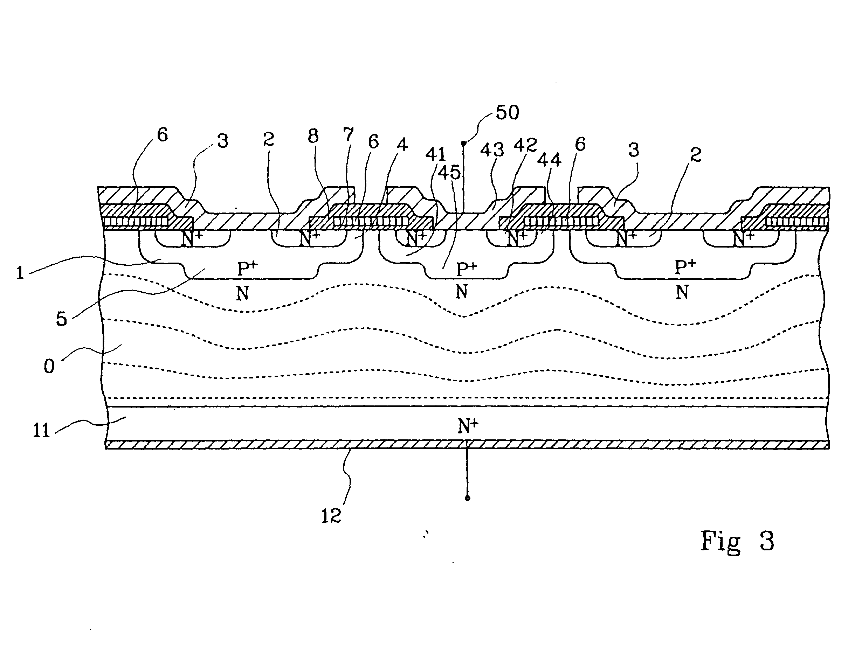

La figure 3 représente une vue en coupe partielle d'un transistor MOS de puissance de type VDMOS incluant un élément détecteur de surtension selon la présente invention. Dans cette figure, des éléments identiques à ceux de la figure 1 sont désignés par des mêmes références numériques. Ainsi, les cellules du transistor de puissance sont formées dans un substrat 0 dont la face arrière comprend une région N⁺ 11 et est revêtue d'une métallisation 12 qui correspondra à la métallisation de drain du transistor MOS. Dans la face avant de la cellule sont formés des caissons 1 de type P comprenant une zone centrale 5 surdopée de type P⁺. Des diffusions de source 2 de forme annulaire sont formées dans chaque caisson et délimitent latéralement une zone de canal 4 surmontée d'une région de grille 6, avec interposition d'une couche isolante 7, couramment une couche d'oxyde. On a en outre représenté une couche d'un isolant, par exemple d'oxyde de silicium 8 entourant la grille 6 pour isoler cette grille de la métallisation de source 3. Cette métallisation de source 3 est, comme on l'a indiqué précédemment, en contact d'une part avec la surface supérieure centrale du caisson 1, d'autre part avec les régions 2 de type N⁺.

La présente invention prévoit d'ajouter à une telle structure au moins une cellule supplémentaire dont les éléments 41 à 48 correspondent respectivement aux éléments 1 à 8 de la cellule d'un transistor MOS de puissance. La seule différence est que tous les éléments de la cellule supplémentaire sont réduits en dimensions latérales par rapport aux éléments de la cellule du transistor MOS de puissance.

On a également représenté en pointillés l'allure des lignes équipotentielles existant dans le substrat 0 quand le drain 12 est soumis à un potentiel relativement élevé par rapport aux métallisations de source 3, alors que le composant n'est pas mis à l'état conducteur, cette tension relativement élevée étant inférieure à la tension de claquage entre la région N du substrat et les régions P⁺ des diverses cellules. On note que, en raison de la dimension plus petite des cellules supplémentaires, la courbure des lignes de champ est plus accentuée au voisinage de ces cellules. Il en résulte, d'une façon connue de l'homme de métier, que, quand le potentiel de drain continue à augmenter par rapport au potentiel de source, le claquage aura lieu d'abord aux emplacements où les lignes de champ sont le plus courbées, c'est-à-dire au niveau des cellules supplémentaires de plus petite dimension. On a donc ainsi constitué par ces cellules supplémentaires de plus petite dimension une diode de détection qui claquera un peu avant les cellules du transistor de puissance.

Etant donné que les cellules supplémentaires ont exactement la même forme mais seulement une plus petite dimension que les cellules du transistor de puissance, la différence entre les tensions de claquage de ces cellules supplémentaires et des cellules du transistor de puissance est bien déterminée et dépend seulement du rapport dimensionnel entre les cellules supplémentaires et les cellules du transistor de puissance.

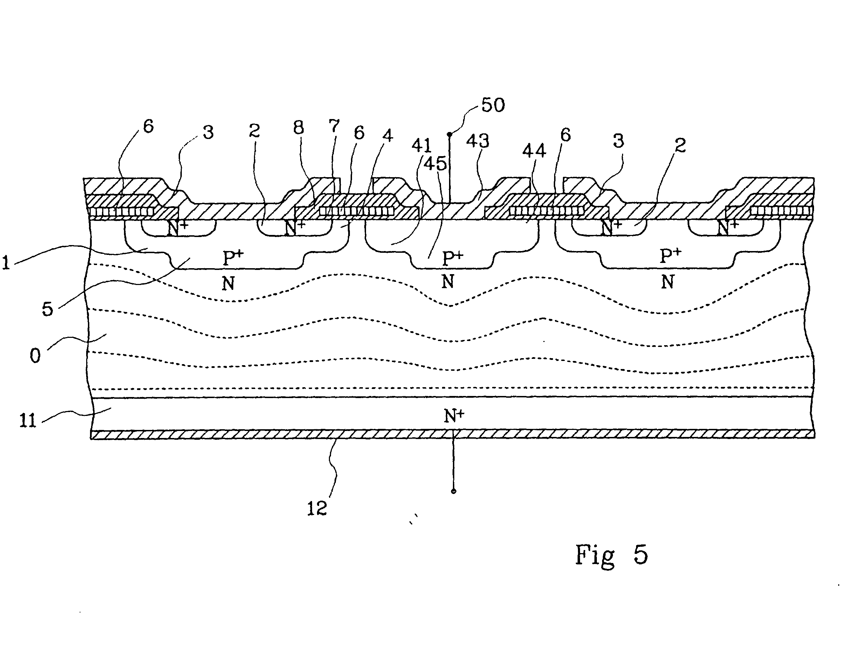

La figure 4 représente la valeur de la tension de claquage BV en fonction de la dimension totale des cellules du transistor de puissance qui, dans cet exemple, sont supposées carrées en vue de dessus. On suppose que la dimension des cellules actives correspond à une valeur SO et celle de la cellule supplémentaire à une valeur Sx. Un écart dimensionnel de quelques micromètres entraîne des variations de tension de claquage de l'ordre de 20 %. L'exemple de la figure 4 correspond à des niveaux de claquage pour un composant de puissance, dans lequel les niveaux de dopage des diverses couches sont par exemple les suivants :

| | |
|---|---|
| région 11 | > 2 à 5 10¹⁸ atomes/cm³, |
| substrat 0 | 2 à 8 10¹⁴ atomes/cm³, |
| régions P⁺ 5 et 45 | 2 à 4 10¹⁸ atomes/cm³, |
| caissons P 1 et 41 | 2 à 4 10¹⁷ atomes/cm³, |
| régions N⁺ 2 et 42 | 2 à 4 10¹⁹ atomes/cm³. |

On pourra selon la présente invention utiliser une ou plusieurs cellules supplémentaires de détection du type de celle illustrée en figure 3. La position de ces cellules par rapport aux cellules du transistor de puissance étant choisie par le concepteur du circuit pour réduire au maximum les différences entre un composant classique et un composant selon la présente invention incluant des diodes supplémentaires de détection. Les cellules supplémentaires pourront par exemple constituer une rangée de cellules intercalée parmi les nombreuses rangées de cellules du composant de puissance. Toutes les métallisations 43 des cellules supplémentaires sont reliées à une même borne 50 et les diodes supplémentaires selon la présente invention seront par exemple connectées dans un montage du type de celui de la figure 2 pour, après apparition d'une surtension ayant provoqué un claquage des diodes supplémentaires, entraîner une mise en conduction momentanée du transistor de puissance TP.

La présente invention est susceptible de nombreuses variantes et modifications qui apparaîtront à l'homme de métier, notamment en ce qui concerne le nombre et la disposition des cellules supplémentaires selon la présente invention et l'utilisation des diodes de détection constituées par ces cellules dans un circuit de mise en conduction d'un transistor principal qui peut être, comme cela a été indiqué précédemment, un transistor de type VDMOS, un transistor bipolaire à grille isolée (IGBT) ou tout composant analogue dans son fonctionnement et sa structure.

On pourrait supprimer les zones N⁺ 42 des cellules supplémentaires puisque, dans ces cellules supplémentaires, ces zones n'ont pas de rôle fonctionnel. La figure 5 représente un transistor VDMOS muni d'un élément détecteur de surtension ne faisant pas partie de l'invention dans lequel ces zones 42 ont été supprimées dans les cellules supplémentaires.

## Revendications

1. Transistor de puissance vertical de type MOS ou IGBT dont la face arrière constitue une première électrode principale (12) et dont la face avant comporte une pluralité de cellules actives identiques de type MOS ou IGBT connectées en parallèle à une deuxième électrode principale (3) et à une électrode de commande (6), caractérisé en ce qu'il comprend en outre :
au moins une cellule supplémentaire (41-45) formée dans la face avant, ayant la même forme que chacune desdites cellules actives, mais ayant de plus petites dimensions latérales, ladite moins une cellule supplémentaire étant fabriquée selon les mêmes étapes technologiques que lesdites cellules actives, et
des moyens pour mettre en conduction le transistor de puissance quand la cellule supplémentaire entre en avalanche.

2. Transistor de puissance vertical de type MOS ou IGBT selon la revendication 1 constitué de ladite pluralité de cellules actives identiques dont chacune comprend du côté de la face supérieure d'un substrat d'un premier type de conductivité un caisson (1) du deuxième type de conductivité à faible niveau de dopage dont la partie centrale (5) est plus profonde et plus dopée, une région sensiblement périphérique et supérieure (2) de chaque caisson ayant un fort niveau de dopage du premier type de conductivité, ladite deuxième électrode principale (3) étant en contact avec la surface supérieure de la région centrale et de la région périphérique, une électrode de commande (6) étant disposée, avec interposition d'une couche isolante (7), au-dessus de la périphérie de chaque caisson, ladite première électrode principale (12) étant formée sur la face inférieure du substrat, ladite au moins une cellule supplémentaire (41, 45) étant disposée parmi elles, chaque cellule supplémentaire étant de plus petites dimensions latérales, au moins en ce qui concerne sa partie plus profonde et plus dopée que les autres cellules et sa deuxième électrode principale étant reliée à un circuit de commande de mise en conduction du transistor de puissance.

3. Transistor de puissance selon l'une des revendications 1 ou 2, caractérisé en ce que les celllules du transistor de puissance sont disposées en rangées et colonnes et en ce que les cellules supplémentaires sont disposées selon une rangée placée parmi les rangées de cellules du transistor de puissance.

## Patentansprüche

1. vertikaler Leistungstransistor vom MOS- oder IGBT-Typ, dessen Rückseite eine erste Hauptelektrode (12) bildet und dessen Vorderseite eine Vielzahl gleichartiger aktiver Zellen vom MOS- oder IGBT- Typ aufweist, die parallel mit. einer zweiten Hauptelektrode (3) und mit einer Steuerelektrode (6) verbunden sind,
**dadurch gekennzeichnet**, daß der Transistor des weiteren umfaßt:
wenigstens eine in der Vorderseite ausgebildete zusätzliche Zelle (41 - 45), welche die gleiche Form wie jede der genannten aktiven Zellen, jedoch kleinere seitliche Abmessungen besitzt, wobei die genannte wenigstens eine zusätzliche Zelle gemäß denselben technologischen Verfahrensstufen wie die genannten aktiven Zellen hergestellt ist, sowie
Mittel zur Einschaltung des Leistungstransistors in den leitenden Zustand, wenn die zusätzliche Zelle in den Lawinendurchbruch übergeht.

2. Vertikaler Leistungstransistor vom MOS- oder vom IGBT-Typ nach Anspruch 1, der von der genannten Vielzahl gleichartiger aktiver Zellen gebildet ist, deren jede jeweils auf der Vorder- bzw. Oberseite eines Substrats eines ersten Leitfähigkeitstyps einen Kasten bzw. Graben (1) vom zweiten Leitfähigkeitstyp niedriger Dotierung aufweist, dessen Mittelbereich (5) tiefer und stärker dotiert ist, wobei ein im wesentlichen periphärer und höher gelegener Bereich (2) jedes Grabens einen starken Dotierungspegel vom ersten Leitfähigkeitstyp aufweist, die genannte zweite Hauptelektrode (3) mit der Oberseite des Mittelbereichs und des periphären Bereichs in Kontakt steht, wobei über dem periphären Bereich jedes Grabens jeweils eine Steuerelektrode (6) unter Zwischenschaltung einer Isolierschicht (7) angebracht ist, wobei die genannte erste Hauptelektrode (12) auf der Unter- bzw. Rückseite des Substrats ausgebildet ist und die genannte wenigstens eine zusätzliche Zelle (41,45) zwischen aktiven Zellen angeordnet ist und jede zusätzliche Zelle wenigstens in ihrem tieferen und stärker dotierten Teil kleinere seitliche Abmessungen wie die anderen Zellen besitzt und ihre zweite Hauptelektrode mit einer Steuerelektrode für die Einschaltung des Leistungstransistors in den leitenden Zustand verbunden ist.

3. Leistungstransistor nach einem der Ansprüche 1 oder 2, dadurch gekennzeichnet daß die Zellen des Leistungstransistors in Zeilen und Spalten angeordnet sind und daß die zusätzlichen Zellen in einer zwischen den Zeilen von Zellen des Leistungstransistors angeordneten Zeile angeordnet sind.

## Claims

1. A MOS or IGBT-type vertical power transistor whose rear surface constitutes a first main electrode (12) and whose front surface includes a plurality of identical MOS or IGBT cells that are parallel connected with a second main electrode (3) and a control electrode (6), said VDMOS transistor characterized in that it further includes:
at least one additional cell (41-45), formed in the front surface, having the same shape but a smaller lateral size than said identical cells, said additional cell being manufactured according to the same technological steps as the active cells, and
means to turn on the power transistor when the additional cell goes to avalanche mode.

2. A VDMOS or IGBT-type power transistor according to claim 1, comprised of said plurality of identical active cells, each of which includes on the side of the upper surface of a substrate of a first conductivity type a low doped well (1) of the second conductivity type, having a deeper and more highly doped central portion (5), a region (2) substantially peripheral and larger than each well having a high doped level of the first conductivity type, said second main electrode (3) contacting the upper surface of the central region and of the peripheral region, a control electrode (6) being disposed, with interpositian of an insulating layer (7), over the periphery of each well, said first main electrode (12) being formed on the lower surface of the substrate, said at least one additional cell (41, 45) being disposed among them, each additional cell having a smaller lateral size, at least at its deeper and more highly doped portion, than the other cells, and its second main electrode being connected to a control circuit for turning the power transistor conductive.

3. The power transistor of claim 1 or 2, characterized in that the cells of the power transistor are arranged in rows and columns, and wherein the additional cells are disposed along a row arranged among the rows of the cells of the power transistor.
